(19) **Europäisches Patentamt / European Patent Office / Office européen des brevets**

(11) **EP 2 051 309 B1**

(12) # FASCICULE DE BREVET EUROPEEN

(45) Date de publication et mention
de la délivrance du brevet:
**30.11.2011 Bulletin 2011/48**

(51) Int Cl.:
**H01L 45/00** *(2006.01)*　　**H01L 27/24** *(2006.01)*

(21) Numéro de dépôt: **08166441.9**

(22) Date de dépôt: **13.10.2008**

(54) **Procédé de fabrication d'une mémoire CBRAM ayant une fiabilité améliorée**

Herstellungsverfahren für einen CBRAM Speicher mit verbesserter Zuverlässigkeit

Method to produce a CBRAM memory having an improved reliability

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **16.10.2007 FR 0758363**

(43) Date de publication de la demande:
**22.04.2009 Bulletin 2009/17**

(73) Titulaire: **Commissariat à l'Énergie Atomique et aux Énergies Alternatives
75015 Paris (FR)**

(72) Inventeurs:
 • **Sousa, Véronique
  38000 Grenoble (FR)**
 • **Dressler, Cyril
  38210 Tullins (FR)**

(74) Mandataire: **Ilgart, Jean-Christophe et al
BREVALEX
95 rue d'Amsterdam
75378 Paris Cedex 8 (FR)**

(56) Documents cités:
**US-A1- 2002 127 886　　US-A1- 2003 043 631
US-A1- 2003 052 330　　US-B1- 6 348 365**

 • **NEALE R: "MICRON TO LOOK AGAIN AT NON-VOLATILE AMORPHOUS MEMORY" ELECTRONIC ENGINEERING, MORGAN-GRAMPIAN LTD. LONDON, GB, vol. 74, avril 2002 (2002-04), pages 56-64, XP009062968 ISSN: 0013-4902**
 • **WANG WEI ET AL: "Structure and property characterization of Bi2-xSbxTe3 thermoelectric films prepared by electrodeposition" WUJI CAILIAO XUEBAO - JOURNAL OF INORGANIC MATERIALS, BEIJING, CN, vol. 20, no. 5, septembre 2005 (2005-09), pages 1234-1238, XP009098535 ISSN: 1000-324X**
 • **ANONYMOUS: "Copper, Cu; Annealed" MATWEB DATASHEET, [Online] XP002476474 Extrait de l'Internet: URL:http://www.matweb.com/search/datasheet _print.aspx?matid=28> [extrait le 2008-04-14]**
 • **ANONYMOUS: "Silver, Ag" MATWEB DATASHEET, [Online] XP002476475 Extrait de l'Internet: URL:http://www.matweb.com/search/DataSheet .aspx?MatID=2> [extrait le 2008-04-14]**
 • **ANONYMOUS: "Tellurium, Te" MATWEB DATASHEET, [Online] XP002476476 Extrait de l'Internet: URL:http://www.matweb.com/search/datasheet _print.aspx?matid=113> [extrait le 2008-04-14]**

EP 2 051 309 B1

**Description**

**DOMAINE TECHNIQUE ET ART ANTERIEUR**

L'invention concerne le domaine des mémoires réinscriptibles, plus particulièrement non volatiles.

L'invention s'applique notamment aux mémoires réinscriptibles non volatiles de type CBRAM.

En fonction des applications et des performances visées, différents types de mémoires sont utilisées.

Lorsque des temps d'écriture ultra-rapides sont requis (comme lors de calcul par un microprocesseur par exemple), on fait appel aux mémoires SRAM constituées par l'agencement de plusieurs transistors.

L'inconvénient de ces mémoires est qu'elles sont volatiles et que la taille du point mémoire, relativement grande, ne permet pas une grande capacité de stockage.

Pour une grande capacité de stockage, on utilise les mémoires DRAM qui consistent à stocker des charges électriques sur une capacité.

Ces mémoires présentent des temps d'écriture plus élevés (quelques 10ns) et elles sont aussi volatiles, le temps de rétention de l'information étant de l'ordre de quelques 10 ms. Enfin, pour des applications qui nécessitent un stockage de l'information même lorsque la tension est coupée, on utilise des mémoires EEPROM ou mémoires FLASH qui permettent de stocker des charges sur la grille flottante d'un transistor à effet de champ. Ces mémoires sont non volatiles. Les inconvénients de ce type de mémoire sont les temps d'écriture longs (quelques microsecondes) et la cyclabilité limitée à 10E6 cycles d'écriture.

Le principe de fonctionnement des mémoires non volatiles réinscriptibles utilisées actuellement (mémoires EEPROM ou Flash) repose sur le stockage de charges électriques sur la grille flottante de transistors à effet de champ.

Chaque point mémoire est donc constitué de un ou plusieurs composants silicium dont la réduction de taille conduit à une diminution du signal de lecture et une diminution de la durée de rétention de l'information. On comprend donc que la densité de ce type de mémoire est limitée.

De plus, ces mémoires présentent des temps d'écriture relativement longs (quelques microsecondes) car c'est le temps nécessaire pour que les électrons passent sur la grille flottante par effet tunnel.

Ces mémoires sont également limitées en cyclabilité ($10^6$). En effet, la rétention diminue au fur et à mesure des cycles d'écriture car la création de défauts dans l'oxyde permet aux électrons de s'échapper de la grille flottante.

Différents concepts de mémoires sont envisagés pour les nouvelles générations de mémoires non volatiles réinscriptibles.

Les matériaux actifs peuvent être des matériaux ferro-électriques (mémoires FERAM), ou magnétiques (mémoires MRAM), ou à changement de phase (mémoires PC-RAM) ou à conduction ionique (mémoires PMC).

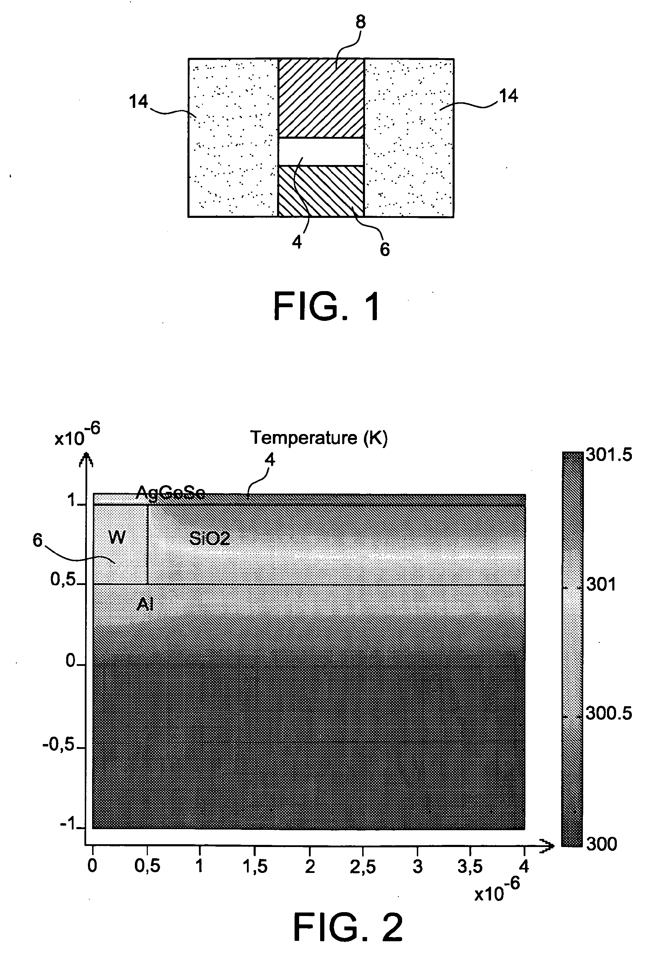

L'invention s'adresse plus particulièrement au domaine des CBRAM et des mémoires PMC. Une cellule mémoire PMC selon l'art antérieur est présentée sur la figure 1.

Le principe de fonctionnement des mémoires PMC repose sur la migration d'ions (par exemple Ag+) dans un électrolyte solide 4 (par exemple GeSe) placé entre une cathode 6 (par exemple en Ni) et une anode soluble 8 (par exemple en Ag).

La référence 14 désigne un milieu isolant.

Le signal de lecture résulte de la différence de résistivité électrique entre deux états ON et OFF.

A l'état OFF, des ions sont dispersés dans la matrice 4 formant une phase de grande résistivité. En appliquant une différence de potentiel de quelques 100mV entre l'anode 8 et la cathode 6, sous la forme d'une impulsion de quelques 10ns, les ions migrent vers la cathode 6 en formant un dépôt métallique. On obtient ainsi l'état ON, de basse résistivité.

En appliquant une différence de potentiel de même intensité et durée mais de signe opposé, le dépôt métallique se redissout sous forme d'ions dans l'électrolyte 4 et on revient à l'état OFF.

Le principal avantage des mémoires PMC réside dans le fait que les tensions d'écriture, inférieures à 1V, sont faibles par rapport à celle des autres mémoires non volatiles (EEPROM, MRAM, PCRAM).

**EXPOSÉ DE L'INVENTION**

Pour obtenir des matrices de points mémoire CBRAM fiables, on cherche à avoir une distribution homogène du matériau d'anode 8. Ceci est très difficile car les ions Ag+ sont très mobiles, en particulier quand ils sont soumis à des sollicitations électriques.

Il est apparu aux inventeurs que, pendant la fabrication d'une telle couche, par exemple en Ag par pulvérisation cathodique, des gradients thermiques vont apparaître dans la couche 4 de matériau chalcogénure : la surface supérieure, soumise au bombardement, reçoit une certaine quantité d'énergie qui se dissipe sous forme de chaleur, et provoque une élévation de température. Cette dernière est différente selon la conductivité thermique du substrat qui comprend différentes structures dans la zone considérée (partie métallique correspondant aux cathodes 6 d'une part et isolant latéral d'autre part). Les matériaux chalcogénures à base de Se ayant de très fort coefficients thermoélectriques (~1mV/K pour Se), les gradients thermiques engendrent des différences de potentiel, les zones les plus froides se chargeant négativement, et attirant ainsi les ions Ag+.

On peut montrer que ces zones sont par exemple la surface des bouchons de tungstène (qui forment les cathodes 6) comme illustré sur la figure 2 qui représente une simulation du profil de température lors d'un apport d'énergie sur la surface d'une mémoire de type connu. Sur cette figure on a identifié les zones 6, 4 (chalcogénure, ici AgGeSe).

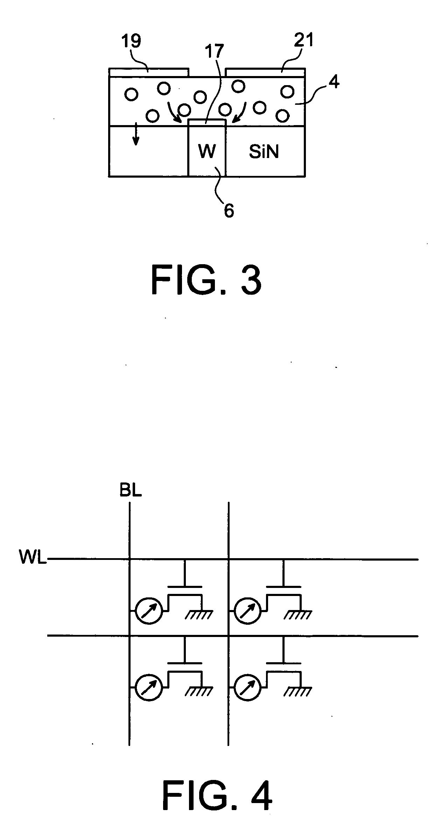

Comme illustré sur la figure 3, on observe, lors du procédé de formation des points mémoire, une agglomération 17 d'argent Ag, qui peut conduire à des déformations des couches et des courts circuits entre les contacts inférieur et supérieur du dispositif. Les références 19 et 21 désignent des excès d'argent restant sur le substrat dans des zones en face du substrat isolant.

Il se pose donc le problème de trouver un nouveau procédé permettant de supprimer, ou au moins de limiter, ces problèmes.

L'invention cherche à résoudre ce problème.

Elle concerne en particulier un procédé de réalisation d'une pluralité de mémoires de type CBRAM, comportant chacune une cellule mémoire en un électrolyte solide de type chalcogénure, une anode, et une cathode, ce procédé comportant :

a) la formation, sur un support semiconducteur, d'une couche isolante,

b) la formation, dans cette couche isolante d'un ensemble de premiers contacts, chacun pour un des points mémoire,

c) la formation, sur cette couche et ces contacts, d'une sous-couche, ou barrière, de matériau de conductivité thermique élevée, supérieure à 1,3W/m/K, qui recouvre l'ensemble des premiers contacts,

d) la formation, sur ladite sous-couche d'un tricouche, comportant une couche de chalcogénure, puis une couche d'anode, et une couche de deuxièmes contacts,

e) une étape de gravure entre les zones situées au-dessus des premiers contacts, pour former des points mémoire individuels, isolés électriquement les uns des autres.

Lors d'un procédé selon l'invention on limite les gradients thermiques dans le matériau chalcogénure, par la présence d'une sous-couche uniforme de conductivité thermique élevée ou forte.

Cette sous-couche, qui peut servir de cathode inerte, peut être gravée en même temps que l'empilement actif. Dans cette configuration, les gradients thermiques, et donc les gradients électriques, sont plus faibles que dans les structures actuellement connues. En conséquence, on observe moins d'accumulation de matériau d'anode sur les contacts, et donc moins de dispositifs en court-circuit.

Lors de l'étape d), on forme, sur la sous-couche de matériau de conductivité thermique élevée, un tricouche, comportant une couche de chalcogénure, puis une couche d'anode et une couche de deuxièmes contacts, ce tricouche étant séparé, en tout point, du substrat, d'une part par la sous couche de matériau de conductivité thermique élevée et d'autre part soit par les premiers contacts, soit par la couche isolante.

La couche d'anode est de préférence en argent pur.

Selon un mode de réalisation, l'étape b) comporte:

- une étape de formation d'une couche métallique sur la couche isolante gravée, pour former les premiers contacts,
- une étape de polissage de ladite couche métallique, jusqu'à la couche isolante et aux premiers contacts.

Selon un autre mode de réalisation, les étapes b) et c) comportant :

- une étape de formation d'une couche métallique sur la couche isolante gravée, pour former les premiers contacts,
- une étape de polissage de ladite couche métallique, qui laisse subsister une couche résiduelle, qui forme la sous-couche de matériau de conductivité thermique élevée.

Le chalcogénure peut être à base de Se.

Il peut être dopé avec un métal ; par exemple il est de type AgGeSe ou de type AgGeSbSe ou de type AgGeS ou AsS ou AsSe.

Une structure de mémoires CBRAM obtenue par un procédé selon l'invention a une fiabilité améliorée.

L'invention permet également une réduction de la topographie au niveau des points mémoire, puisque les effets résultant de la présence d'amas métalliques au niveau des cathodes sont eux aussi réduits.

## BRÈVE DESCRIPTION DES DESSINS

- La figure 1 représente un dispositif de type PMC connu,
- la figure 2 représente une simulation du profil de température lors d'un apport d'énergie sur la surface, dans un procédé connu,
- la figure 3 est un schéma de principe de l'agglomération de l'Ag sur des plots de contact,
- la figure 4 représente schématiquement une matrice de mémoires PMC,
- les figures 5A - 5G représentent des étapes de réalisation d'un procédé selon l'invention,
- les figures 6A et 6B sont des étapes d'une variante d'un procédé selon l'invention,
- les figures 7A et 7B représentent une distribution calculée de température dans une structure CBRAM sans couche barrière et, selon l'invention, avec couche barrière,
- la figure 8 est un profil de température suivant une direction latérale, au niveau de l'interface inférieure de la couche de matériau chalcogénure, dans une structure CBRAM sans couche barrière et, selon l'invention, avec couche barrière,
- la figure 9 représente l'évolution du nombre de dispositifs en court-circuit, en fonction de l'épaisseur de la sous-couche barrière.

## EXPOSÉ DÉTAILLÉ DE MODES DE RÉALISATION PARTICULIERS

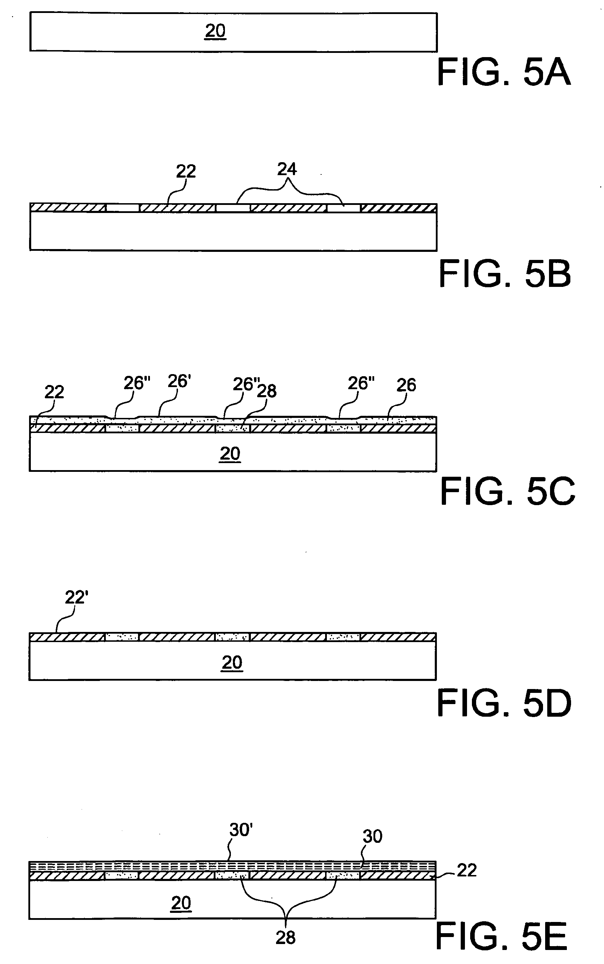

Un premier exemple d'un procédé selon l'invention, pour réaliser des mémoires PMC, va être décrit en liaison avec les figures 5A - 5E.

Un substrat 20, par exemple en silicium, est tout d'abord sélectionné (figure 5A). Ce substrat peut contenir des composants, non représentés sur la figure. Dans ce substrat peuvent avoir préalablement été réalisés les transistors d'adressage des futurs points mémoires. La figure 4 représente une matrice de 4 points mémoires PMC selon l'invention, commandés par des signaux de ligne WL et de colonnes BL.

Une couche 22 de matériau isolant, par exemple une couche d'oxyde SiO2, ou de nitrure Si3N4, est ensuite formée sur ce substrat 20. Puis, par gravure, on dégage des ouvertures 24 dans cette couche 22 jusqu'à la surface du substrat 20 (figure 5B). Ces ouvertures vont localiser les futurs points mémoires.

Une couche métallique 26 recouvre ensuite l'ensemble et des dépôts métalliques 28 viennent simultanément combler les ouvertures 24 qui ont été gravées précédemment. En fait, le dépôt 26 ainsi réalisé est un dépôt conforme : la surface 26' n'est pas uniformément plane ; au contraire, elle reproduit la présence des cavités 24 au droit desquelles elle peut être légèrement affaissée (voir zones 26" de la figure 5C). Les dépôts 28 formés dans les cavités 24 sont destinés à devenir les contacts de chacun des points mémoire individuels.

Il est ensuite procédé à une étape de polissage, par exemple un polissage mécanochimique (figure 5D) jusqu'à atteindre une surface 22', qui est soit la surface de la couche 22 soit une surface obtenue en gravant jusqu'à un niveau inférieur à celui défini par la surface initiale de la couche 22. La partie libre des dépôts 28 affleure cette surface 22'.

Sur cette surface 22', une couche 30 peut être formée uniformément (figure 5E). Le matériau de cette couche a une conductivité thermique supérieure à celle du matériau chalcogénure qui sera ensuite déposé ; cette conductivité thermique est donc de préférence égale à 1.3W/m/K ou, de préférence encore, supérieure à cette valeur, par exemple supérieure à 50 W/m/K ou encore à 100W/m/K ; c'est par exemple un matériau métallique bon conducteur ou du carbone. Les différents contacts 28 précédemment réalisés sont tous reliés et en contact par l'intermédiaire de cette même couche 30.

Pour être continue celle-ci a une épaisseur au moins égale à une couche atomique, mais elle est de préférence d'épaisseur au moins égale à 1 nm, et elle est, de préférence encore, supérieure à 5 nm pour que ses propriétés thermiques soient uniformes dans le plan du substrat sur lequel elle est réalisée. La limite supérieure de l'épaisseur de cette couche 30 dépend du matériau qui la compose, mais aussi du matériau chalcogénure utilisé ensuite pour les points mémoires. Par exemple, elle est telle que la résistance série qu'elle apporte ne dépasse pas la résistance de l'état passant de la future cellule mémoire, i.e. quelques 10kΩ, par exemple 20kΩ. ou 50kΩ. Typiquement, son épaisseur est inférieure à 50 nm.

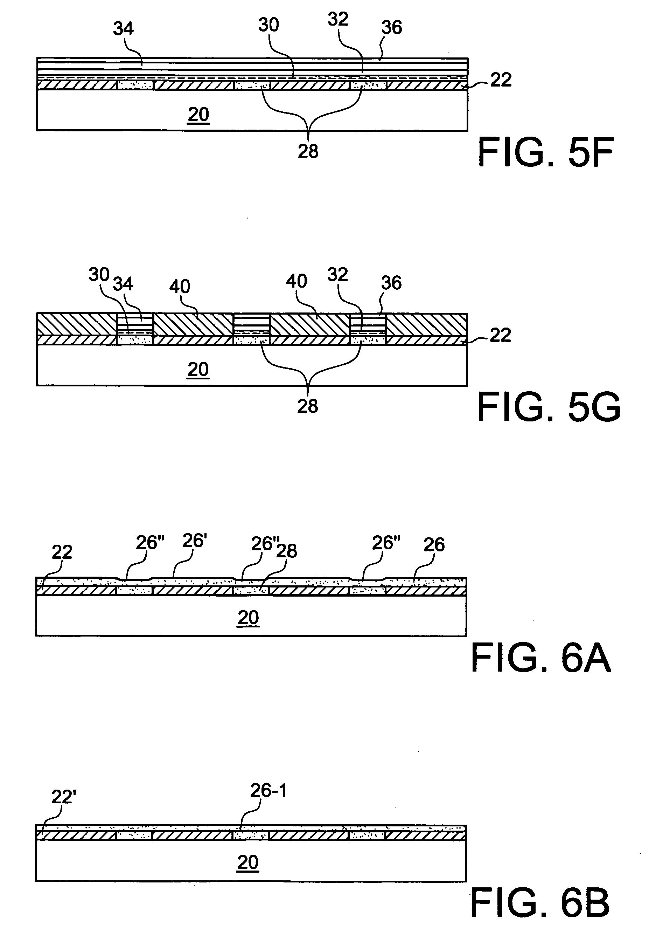

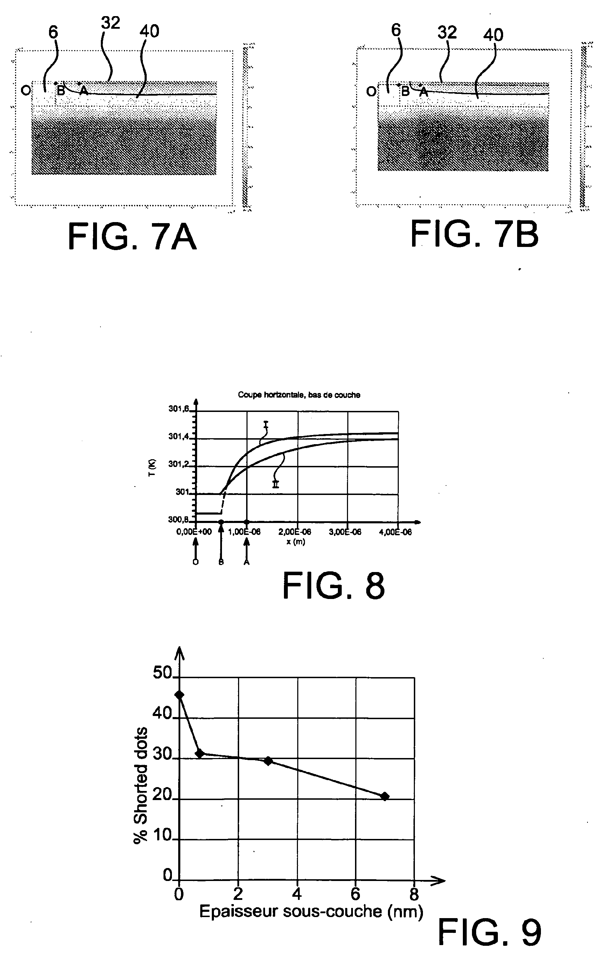

La surface 30' de cette couche 30 va pouvoir servir de surface de départ pour la réalisation des différentes étapes de formation de points mémoire PMC. On peut donc déposer sur cette surface 30' une couche 32 de chalcogénure, puis une couche 34 d'anode, par exemple en argent (le plus pur possible) ou en cuivre, et, enfin, une couche 36 de contacts (figure 5F). Au cours de ces étapes, on va pouvoir constater que, grâce à la présence de la sous-couche 30, la migration d'atomes de la couche d'anode 34 est fortement limitée. Comme on le voit sur la figure 9 (décrite plus loin), un effet bénéfique est sensible dès les plus petites épaisseurs de la sous-couche 30, en particulier dès 0,5 nm ou 0,7 nm d'épaisseur.

L'empilement ainsi constitué peut ensuite subir des opérations de photolithographie et de gravure entre les zones qui sont situées au niveau des points mémoire, c'est-à-dire entre les zones, ou plots, situées juste au-dessus des contacts formés par les dépôts 28 (figure 5G). Cette gravure va permettre d'éliminer les portions de la sous-couche 30 qui relient entre eux les contacts 28 des différents points mémoires. On obtient ainsi des plots ou des points mémoire individuels, isolés électriquement les uns des autres. Mais chacun de ces points garde trace du procédé de réalisation, du fait de la présence d'une portion résiduelle de la sous-couche 30. La référence 40 désigne un matériau isolant (par exemple SiO2) qui peut être déposé, puis planarisé, entre les différents points mémoire ainsi réalisés.

Une variante du procédé ci-dessus va être expliquée à l'aide des figures 6A et 6B. La figure 6A est d'ailleurs identique à la figure 5C, mais le matériau de la couche 26 est celui sur lequel le tricouche 32, 34, 36 va pouvoir être directement déposé, après une opération de polissage qui, cette fois, ne va pas être poursuivie jusqu'à la surface 22' et va donc laisser subsister une couche 26-1 (figure 6B). La conductivité thermique du matériau de la couche 26 est donc élevée, supérieure ou égale à 1.3W/m/K ou, de préférence encore, supérieure à 50 W/m/K ou encore à 100W/m/K; c'est par exemple un matériau métallique bon conducteur ou du carbone. Les différents contacts 28 précédemment réalisés sont tous reliés et en contact par l'intermédiaire de cette même sous-couche 26-1. L'épaisseur de cette dernière est, comme déjà expliqué ci-dessus pour la couche 30, au moins égale à 1 nm, et, de préférence encore, supérieure à 5 nm et inférieure à 50 nm, et peut être choisie en fonction des mêmes critères (la résistance série que la couche 26-1 apporte ne dépasse pas la résistance de l'état passant de la future cellule mémoire, i.e. quelques 10kΩ, par exemple 20kΩ. ou 50kΩ). Ensuite, les étapes des figures 5F et 5G peuvent être enchaînées. L'avantage de cette variante est qu'il n'est pas nécessaire de déposer une nouvelle couche 30 après un polissage réalisé jusqu'à la surface 22'.

Ainsi, quelle que soit la variante mise en oeuvre, la couche 32 de chalcogénure est déposée sur une surface 30 ou 26-1 uniforme en température et présentant une conductivité thermiques élevée.

La migration d'atomes de la couche d'anode 34 est fortement limitée grâce à un procédé selon l'invention ; ce dernier permet donc, notamment, de réaliser une couche d'anode en argent le plus pur possible, ce qui évite d'avoir à recourir, pour le matériau d'anode, à des matériaux tels que le séléniure d'argent AgSe.

Le calcul ci-dessous permet d'évaluer la distance parcourue par des atomes d'argent dans du GeSe sous effet thermoélectrique.

On peut d'abord évaluer le nombre de porteurs de charges n.

Partant du volume atomique (en cm$^3$/mol):

- de l'argent : 10.3 cm$^3$/mol,
- du germanium : 13.6 cm$^3$/mol,
- du Selenium : 16.5 cm$^3$/mol,

on obtient le volume molaire du chalcogénure Ag$_{33}$Ge$_{17}$Se$_{50}$: ~ 1396 cm$^3$/mol (soit 7,16 x 10$^{-4}$ mol/cm$^3$) .

A saturation, le matériau chalcogénure accepte jusqu'à 33% d'atomes de Ag dont 20% sont mobiles. On a donc 4,7x10$^{-3}$ mol d'atomes d'Ag mobiles par cm$^3$, soit environ n = 2,85x10$^{21}$ at/cm$^3$ d'atomes d'Ag mobiles. La mobilité de ces atomes peut être évaluée de la manière suivante.

Soit δ1a conductivité électrique (environ 3x10$^{-4}$Ω$^{-1}$·cm$^{-1}$), q la charge élémentaire des porteurs (= 1.6 x 10$^{-19}$ C), n la densité de porteurs de charge (2,85 x 10$^{21}$ cm$^{-3}$), m la mobilité (en m$^2$ V$^{-1}$.s$^{-1}$). On a:

$$\sigma = q \cdot n \cdot \mu$$

$$\mu = \sigma / q \cdot n\ 3\ x\ 10^{-2} / (1.6\ x\ 10^{-19} \cdot 4\ x\ 10^{27}) = 6.6\ x\ 10^{-11}\ m^2.V^{-1}.s^{-1}$$

Δl (distance de parcours) et t (temps de parcours) peuvent également être évalués. Soient v la vitesse de déplacement des ions, μ leur mobilité, AV le gradient de potentiel électrique et E le champ électrique. De :

$$v = \Delta l / t = \mu \cdot E,\ et\ E = \Delta V / \Delta l$$

on déduit :

$$\Delta l = sqrt (\mu \cdot \Delta V \cdot t)$$

$$t = \Delta l^2 \; / \; \mu \; / \; \Delta V$$

Pour les composés à base de Se, on peut ensuite calculer l'effet thermoélectrique, avec un gradient exercé sur 1 $\mu$m. Soit S le coefficient thermoélectrique (en mV/K, S=+1 mV/K pour Se) :

$$\Delta T \; = \; 1K \; \Rightarrow \; \Delta V \; = \; 1mV \; et \; t \; = \; 15s.$$

Ce calcul montre que, si un écart de température de 1K apparaît sur une distance de 1$\mu$m, il faudra de l'ordre de 20s à l'argent pour parcourir cette distance. Le temps de dépôt étant de l'ordre de la minute, ceci explique l'apparition de zones déplétées en Ag sur une extension de l'ordre du micron autour des bouchons en tungstène 6 (voir figure 3). La solution à ce problème consiste justement à réaliser un procédé selon la présente invention, en particulier conformément à l'une des variantes exposées ci-dessus.

On peut aussi optimiser l'épaisseur et le matériau de la couche 30 à l'aide de simulations électro-thermiques, qui peuvent être par exemple réalisées à l'aide d'un logiciel de modélisation multiphysique commercial comme par exemple le logiciel FEMLAB.

Des résultats de modélisation, qui permettent d'illustrer l'influence de la sous-couche 30, sont donnés en figures 7A et 7B, qui montrent la distribution de température calculée pour un empilement CBRAM, sans sous-couche (figure 7A) et avec une sous-couche (figure 7B). Ce calcul a été effectué pour une sous-couche 30 (en tungstène) d'épaisseur 10 nm et de conductivité thermique égale à 174W/m/K (conductivité du tungstène).

Sur ces figures, on distingue un plot 6 (en tungstène), tandis que la référence 40 correspond au matériau isolant (en SiO2) environnant. La couche 32 est en chalcogénure. Deux points A et B sont identifiés sur ces figures: le point B est à la limite entre le plot conducteur, la zone isolante, et la couche 32 en chalcogénure, tandis que le point A est localisé à la limite de l'isolant et du chalcogénure.

La figure 8 représente deux profils de température (en K), suivant une direction qui suit la limite inférieure de la couche de chalcogénure 32, depuis le point O (voir figures 7A et 7B) situé à l'interface entre la couche de chalcogénure et le plot.

Le profil I correspond au cas de la figure 7A, sans sous-couche 30, tandis que le profil II correspond au cas de la figure 7B, avec sous-couche 30. On voit que ce deuxième profil est plus écrasé que le premier, il a une amplitude maximum de 0,4 K, tandis que le premier a une amplitude d'environ 0,8 8 K. En ce qui concerne les deux points A et B, on voit que la température au point A est réduite lorsqu'on passe du profil I au profil II, tandis que celle au point B augmente : il y a donc un aplatissement global, ou une uniformisation, de l'ensemble des températures, lorsqu'une sous-couche 30 ou 26-1 est, conformément à l'invention, introduite dans l'empilement. Cette uniformisation des températures permet de réduire fortement les phénomènes d'agglomération décrits ci-dessus, en liaison avec la figure 3 notamment.

Des dispositifs CBRAM ont été réalisés, avec une barrière 30 inférieure en carbone. Différentes épaisseurs de barrière ont été testées, de 0,7 à 7 nm. L'empilement actif est le suivant :

- couche 30 en carbone, avec différentes épaisseurs 0.7 nm, 3 nm ou 7 nm,
- couche 32 de chalcogénure GeSe, d'épaisseur 55 nm,
- couche 34 d'Ag, d'épaisseur 40 nm,
- couche 36 de contacts en Au, d'épaisseur 140 nm.

En outre des dispositifs de structure connue, sans couche 30 en carbone, ont été également réalisés.

La figure 9 représente la proportion de dispositifs en court-circuit, en sortie de fabrication, en fonction de l'épaisseur de la sous-couche 30 (en carbone). On constate une chute rapide du taux de dispositifs en court-circuit lorsque l'épaisseur de la couche 30 augmente : ce taux passe d'une valeur, comprise entre 45% et 50% pour des dispositifs sans sous-couche 30 ou 26-1, à environ 30% pour une sous-couche d'épaisseur sensiblement égale à 0,7 nm (au point A sur la figure ; 0,7 nm correspond à l'une des épaisseurs testées, cf ci-dessus). Puis, jusqu'à une épaisseur d'environ 3 nm, cette proportion semble peu évoluer, pour décroître de nouveau sensiblement au-delà de 3 nm. Pour une épaisseur supérieure à 3 nm ou 4 nm, elle passe à une valeur comprise, sensiblement, entre 20% et 30%. Le nombre de dispositifs défaillants est donc à peu près divisé par 2 en moyenne grâce à la barrière inférieure 30. Lorsque l'épaisseur de la couche 30 dépasse 4 nm ou 5 nm, l'amélioration est meilleure que 50%. L'invention permet donc une augmentation du rendement de dispositifs fonctionnels dans une matrice de points mémoire de type PMC.

**Revendications**

1. Procédé de réalisation d'une pluralité de mémoires de type CBRAM, comportant chacune une cellule mémoire en un électrolyte solide de type chalcogénure, une première électrode, et une deuxième électrode, ce procédé comportant :

   a) la formation, sur un support semiconducteur (20), d'une couche isolante (22),
   b) la formation, dans cette couche isolante (22) d'un ensemble de premiers contacts (28), chacun pour un des points mémoire,
   c) la formation, sur cette couche et ces contacts, d'une sous-couche (30, 26-1) de matériau de conductivité thermique élevée, supérieure à 1,3W/m/K, qui recouvre l'ensemble des premiers contacts (28),
   d) la formation, sur ladite sous-couche (30, 26-1) d'un tricouche (32, 34, 36), comportant une couche de chalcogénure (32), puis une couche de première électrode (34), et une couche de deuxièmes contacts (36),
   e) une étape de gravure entre les zones situées au-dessus des premiers contacts (28), pour former des points mémoire individuels, isolés électriquement les uns des autres.

2. Procédé selon la revendication 1, la sous-couche (30, 26-1) étant en un matériau de conductivité thermique supérieure à 100 W/m/K.

3. Procédé selon la revendication 1 ou 2, la sous-couche (30, 26-1) étant en un matériau métallique.

4. Procédé selon l'une des revendications 1 à 3, la sous couche (30, 26-1) ayant une épaisseur supérieure à 1 nm ou à 5 nm et inférieure à 50 nm ou à 100 nm.

5. Procédé selon l'une des revendications 1 à 4, le chalcogénure étant à base de Se.

6. Procédé selon l'une des revendications 1 à 5, la couche de première électrode (34) étant en argent.

7. Procédé selon l'une des revendications 1 à 6, l'étape b) comportant :

   - une étape de formation d'une couche métallique (26) sur la couche isolante (22) gravée, pour former les premiers contacts (28),
   - une étape de polissage de ladite couche métallique (26), jusqu'à la couche isolante (22) et aux premiers contacts (28).

8. Procédé selon l'une des revendications 1 à 6, les étapes b) et c) comportant :

   - une étape de formation d'une couche métallique (26) sur la couche isolante (22) gravée, pour former les premiers contacts (28),
   - une étape de polissage de ladite couche métallique (26), qui laisse subsister une couche résiduelle (26-1), qui forme la sous couche de matériau de conductivité thermique élevée.

9. Procédé selon l'une des revendications 1 à 8, comportant une étape de formation de transistors d'adressage dans le substrat (20).

10. Procédé selon l'une des revendications 1 à 9, le chalcogénure étant dopé avec un métal.

11. Procédé selon la revendication 10, le chalcogénure dopé métal étant de type AgGeSe ou de type AgGeSbSe ou de type AgGeS ou AsS ou AsSe.

**Claims**

1. A process for manufacturing a plurality of CBRAM memories, each comprising a memory cell in a chalcogenide solid electrolyte, an anode and a cathode, wherein the process comprises:

   a) providing, on a semiconductor support (20), an insulating layer (22),
   b) providing, in said insulating layer (22) a set of first contacts (28), each for one of the memory points,

c) providing, on said layer and said contacts, a sublayer (30, 26-1) made of a high thermal conductivity material, higher than 1.3 W/m/K, which covers the set of first contacts (28),

d) providing, on said sublayer (30, 26-1), a triple layer (32, 34, 36) comprising a chalcogenide layer (32), then an anodic layer (34), and a layer of second contact (36),

e) an etching step between the areas located above the first contacts (28), in order to provide individual memory points, electrically insulated from each other.

2. The process according to claim 1, wherein the sublayer (30, 26-1) is made of a material having a thermal conductivity higher than 100 W/m/K.

3. The process according to claim 1 or 2, wherein the sublayer (30, 26-1) is made of a metal material.

4. The process according to any of claims 1 to 3, the sublayer (30, 26-1) having a thickness larger than 1 nm or 5 nm and smaller than 50 nm or 100 nm.

5. The process according to any of claims 1 to 4, wherein the chalcogenide is based on Se.

6. The process according to any of claims 1 to 5, wherein the anodic layer (34) is made of silver.

7. The process according to any of claims 1 to 6, wherein step b) comprises:

- a step of providing a metal layer (26) over the insulating layer (22) etched to provide the first contacts (28),
- a step of polishing said metal layer (26), up to the insulating layer (22) and the first contacts (28).

8. The process according to any of claims 1 to 6, wherein steps b) and c) comprise:

- a step of providing a metal layer (26) over the insulating layer (22) etched to provide the first contacts (28),
- a step of polishing said metal layer (26), which leaves a residual layer (26-1), which forms the sublayer made of a high thermal conductivity material.

9. The process according to any of claims 1 to 8, comprising a step of providing addressing transistors in the substrate (20).

10. The process according to any of claims 1 to 9, wherein the chalcogenide is doped with a metal.

11. The process according to claim 10, wherein the metal doped chalcogenide is of the AgGeSe type or of the AgGeSbSe type or of the AgGeS or AsS or AsSe type.


**Patentansprüche**

1. Verfahren zur Herstellung einer Mehr- bzw. Vielzahl von Speichern vom CBRAM-Typ, deren jeder jeweils eine Speicherzelle in einem Feststoffelektrolyten vom Chalcogen-Typ, eine erste Elektrode und eine zweite Elektrode aufweist, wobei das Verfahren umfaßt:

a) Ausbilden einer Isolierschicht (22) auf einem Halbleiter-Träger (20),

b) Ausbilden einer Gruppe bzw. eines Ensembles erster Kontakte (28) in dieser Isolierschicht (22), und zwar jeweils jeder für einen der Speicherpunkte,

c) über dieser Schicht und diesen Kontakten Ausbilden einer Sub- bzw. Teilschicht (30, 26-1) aus einem Material mit erhöhter Wärmeleitfähig-keit größer als 1,3 W/m/K, welche die Gruppe bzw. das Ensemble der ersten Kontakte (28) überdeckt,

d) Ausbilden auf der genannten Sub- bzw. Teilschicht (30, 26-1) eines dreilagigen Schichtstapels (Dreierschicht) (32, 34, 36) umfassend eine Chalcogen-Schicht (32), sodann eine Schicht einer ersten Elektrode (34), und eine Schicht zweiter Kontakte (36),

e) eine Verfahrensstufe zum Ätzen zwischen den über den ersten Kontakten (28) liegenden Zonen, zur Bildung individueller, voneinander isolierter Speicherpunkte.

2. Verfahren nach Anspruch 1, wobei die Sub- bzw. Teilschicht (30, 26-1) aus einem Material mit einer elektrischen Leittähigkeit größer als 100 W/m/K besteht.

3. Verfahren nach Anspruch 1 oder 2, wobei die Sub-bzw. Teilschicht (30, 26-1) aus einem metallischen Material besteht.

4. Verfahren nach einem der Ansprüche 1 bis 3, bei welchem die Sub- bzw. Teilschicht (30, 26-1) eine Dicke von mehr als 1 nm oder von mehr als 5 nm und von kleiner als 50 nm oder kleiner als 100 nm besitzt.

5. Verfahren nach einem der Ansprüche 1 bis 4, wobei das Chalcogen ein Material auf der Basis von Se ist.

6. Verfahren nach einem der Ansprüche 1 bis 5, bei welchem die Schicht erster Elektrode (34) aus Silber besteht.

7. Verfahren nach einem der Ansprüche 1 bis 6, bei welchem die Verfahrensstufe b) umfaßt:

- eine Verfahrensstufe der Ausbildung einer Metallschicht (26) auf der geätzten Isolierschicht (22), zur Bildung der ersten Kontakte (28),
- eine Verfahrensstufe zum Schleifpolieren der genannten Metallschicht (26) bis auf die Isolierschicht (22) und auf die ersten Kontakte (28).

8. Verfahren nach einem der Ansprüche 1 bis 6, wobei die Verfahrensstufen b) und c) umfassen:

- eine Stufe der Ausbildung einer Metallschicht (26) auf der geätzten Isolierschicht (22), zur Bildung der ersten Kontakte (28),
- eine Verfahrensstufe zum Schleifpolieren der genannten Metallschicht (26), welche eine verbleibende Restschicht (26-1) stehen lässt welche die Sub- bzw. Teilschicht aus dem Material erhöhter Wärmeleltfähigkeit bildet.

9. Verfahren nach einem der Ansprüche 1 bis 8, welches eine Stufe der Ausbildung von Addressierungs-Transistoren in dem Substrat (20) umfaßt.

10. Verfahren nach einem der Ansprüche 1 bis 9, bei welchem das Chalcogen mit einem Metall dotiert ist.

11. Verfahren nach Anspruch 10, bei welchem das mit Metall dotierte Chalcogen vom Typ AgGeSe oder vom Typ AgGeSbSe oder vom Typ AgGeS oder AsS oder AsSe ist.

## FIG. 1

## FIG. 2

# FIG. 3

# FIG. 4

**20**

FIG. 5A

22      24

FIG. 5B

22   26"  26'   26"28        26"   26
                                    20

FIG. 5C

22'
            20

FIG. 5D

30'              30
                              22
         20
              28              FIG. 5E

FIG. 5F

FIG. 5G

FIG. 6A

FIG. 6B

## FIG. 7A

6    32    40

O   B  A

## FIG. 7B

6    32    40

O   B  A

Coupe horizontale, bas de couche

T (K)

301,6

301,4

301,2

301

300,8

0,00E+00   1,00E-06   2,00E-06   3,00E-06   4,00E-06

x (m)

O   B   A

## FIG. 8

% Shorted dots

50

40

30

20

10

0

0    2    4    6    8

Epaisseur sous-couche (nm)

## FIG. 9